# Europäisches Patentamt

## European Patent Office

## Office européen des brevets

(19)

(11) Veröffentlichungsnummer: **0 267 874**
**B1**

(12) **EUROPÄISCHE PATENTSCHRIFT**

(45) Veröffentlichungstag der Patentschrift:
27.06.90

(51) Int. Cl.⁵: **B65G 47/91**, B65G 59/04, H05K 13/00

(21) Anmeldenummer: 87810636.8

(22) Anmeldetag: 04.11.87

(54) Verfahren zum Transportieren von perforierten plattenförmigen Objekten.

(30) Priorität: 10.11.86 CH 4481/86

(43) Veröffentlichungstag der Anmeldung:
18.05.88 Patentblatt 88/20

(45) Bekanntmachung des Hinweises auf die Patenterteilung:
27.06.90 Patentblatt 90/26

(84) Benannte Vertragsstaaten:
CH DE FR GB IT LI NL SE

(56) Entgegenhaltungen:
DE-A- 1 756 327
DE-A- 3 009 580
DE-C- 850 797
US-A- 2 880 030

PATENT ABSTRACTS OF JAPAN, Band 6,
Nr. 249 (M-177)[1127], 8. Dezember 1982; &
JP-A-57 145 723 (UEMURA KOGYO K.K.) 08-09-1982

(73) Patentinhaber: Haas-Laser Systems AG,
Pumpwerkstrasse 23, CH-8105 Regensdorf(CH)

(72) Erfinder: Marzinotto, Francesco, Wehntalerstrasse 176,
CH-8057 Zürich(CH)
Erfinder: Junghans, Jürgen, Dr., Dorzenmatten 78,
CH-3313 Büren z. Hof(CH)

(74) Vertreter: Marx, Lothar, Dr. et al, Patentanwälte
Schwabe, Sandmair, Marx
Stuntzstrasse 16 Postfach 86 02 45,
D-8000 München 80(DE)

ACTORUM AG

## Beschreibung

Die Erfindung betrifft ein Verfahren gemäss Oberbegriff des Anspruchs 1. Ein solches Verfahren ist bekannt (JP-A 57 145 723).

In der Elektronik-Industrie kommt es vielfach vor, dass auf einem Stapel befindliche Leiterplatten Stück für Stück vom Stapel abgenommen und der weiteren Bearbeitung oder Verwendung zugeführt werden müssen. Üblicherweise werden dazu mehr oder weniger automatisierte Transportvorrichtungen verwendet, die in der Regel mit einem Greiferkopf ausgestattet sind, welcher die Platten mittels Saugwirkung festhält. Bei perforierten Leiterplatten kommt es dabei aber insofern zu Schwierigkeiten, als oftmals nicht nur die oberste Platte allein, sondern unerwünschterweise gleich zwei oder mehrere Platten gleichzeitig vom Stapel abgehoben werden.

Durch die Erfindung soll nun dieses Problem überwunden und ein Transportverfahren der zur Rede stehenden Gattung dahingehend verbessert werden, dass sie auch im Falle von perforierten Platten ein einwandfreies Abnehmen einzelner Platten von einem Stapel gewährleistet. Insbesondere soll dies mit möglichst einfachen konstruktiven Mitteln erreicht werden.

Diese der Erfindung zugrunde liegende Aufgabe ist durch die im Patentanspruch 1 angeführten Merkmale gelöst. Besonders zweckmässige Verfahrensführungen ergeben sich aus den abhängigen Ansprüchen.

Gemäss dem Grundgedanken der Erfindung werden also ausgewählte Bereiche der Saugplatte abgedeckt und somit desaktiviert. Durch entsprechende Formgebung der Abdeckmaske können somit die verbleibenden saugaktiven Bereiche der Saugplatte individuell an die zu transportierenden Leiterplatten angepasst werden, d.h., die saugaktiven Bereiche können so bemessen und angeordnet werden, dass sie auf diejenigen Bereiche der Leiterplatten fallen, in denen diese keine oder nur relativ wenige Perforationen aufweisen. Auf diese Weise kann sich die Saugwirkung des Greiferkopfs nicht durch die Perforationen hindurch auf die im Stapel darunter liegenden Leiterplatten übertragen, und die jeweils oberste Leiterplatte kann daher problemlos vom Stapel abgehoben werden.

In der DE-A 1 756 327 ist eine Vorrichtung zum Be- und Entladen von Paletten beschrieben. Diese Vorrichtung weist u.a. einen Vakuum-Greifer auf, dessen dem zu greifenden Gut zugewandte Seite durch eine mit Öffnungen versehene Platte abgeschlossen ist, wobei diese Platte in ihrer Mitte einen dichten Bereich aufweist, an dessen Unterseite ein elastisches Dichtungselement angeordnet ist. Der Zweck dieses dichten Bereichs besteht darin, allfällige Zwischenräume zwischen mehreren zu greifenden Gegenständen abzudichten, so dass die Saugwirkung nicht verloren geht. Das der Erfindung zugrunde liegende Problem ist in dieser Druckschrift jedoch nicht angesprochen.

In der US-A 2 880 030 ist eine Vorrichtung zum Be- und Entladen von Paletten mit Paketen beschrieben. Die Vorrichtung weist einen Vakuum-greifer auf, der mit seitlich herabhängenden flexiblen Schürzen ausgestattet ist. Die Saugplatte ist durch ein Metallgitter gebildet. Am Rande des Metallgitters und elastische Abdeckklötze im Abstand voneinander befestigt. Zum Aufheben einer Lage von Paketen (Zuckerpakete, Mehlpakete...) wird der Vakuumgreifer auf die oberste Paketlage gesetzt. Beim Aufbauen des Vakuums innerhalb des Vakuumgreifers strömt die Luft durch die Zwischenräume zwischen den Abdeckklötzen. Dadurch werden die seitlich herabhängenden Schürzen dicht abschliessend an die Seiten der Paketlage angesaugt. Um auch bei Paketlagen, deren Schlichtmuster grössere Lücken aufweist, ein Vakuum aufbauen zu können, werden diese Lücken mit einer oder mehreren Dichtplatten abgedichtet, so dass die Saugwirkung nicht verloren geht. Das der Erfindung zugrunde liegende Problem ist in dieser Druckschrift nicht angesprochen. Aufgrund des Konzeptes mit seitlich herabhängenden flexiblen Dichtungsschürzen ist die Vorrichtung überdies auch nicht dazu geeignet, mit einer Vielzahl von Perforationen versehene plattenförmige Objekte einzeln von einem Stapel abzunehmen.

In der JP-A 57 145 723 ist eine Transportvorrichtung zum einzelnen Abheben von perforierten Leiterplatten beschrieben. Diese bekannte Vorrichtung weist einen Greiferkopf auf, der als eine in mehrere getrennte Saugbereiche unterteilte Saugglocke ausgebildet ist. Jeweils mehrere Saugbereiche sind zu Gruppen zusammengefasst. Die einzelnen Gruppen sind über Ventile, welche zwischen der Saugglocke und einer Saugeinrichtung angeordnet sind, aktivier- bzw. deaktivierbar. Auf diese Weise ist die Saugglocke in ein fest vorgegebenes Muster saug-aktiver Bereiche einteilbar. Leiterplatten, deren Perforationen hauptsächlich in Bereichen angeordnet sind, die mit der einen oder anderen fest vorgegebenen, separat aktivier- oder deaktivierbaren Gruppe von Saugbereichen übereinstimmen, können einzeln von einem Stapel abgehoben werden. Leiterplatten hingegen, deren Perforationsmuster nicht mit diesen Gruppen übereinstimmt, oder deren Perforationen gleichmässig über die Leiterplatten verteilt sind, können nicht mehr zuverlässig einzeln abgehoben werden. Eine Anpassung der saug-aktiven Bereiche an das Perforationsmuster derartiger Platten ist überdies praktisch nicht möglich.

Weitere Vakuum-Greifvorrichtungen sind in DE-A 850 797 und DE-A 3 009 580 beschrieben.

Im folgenden wird die Erfindung anhand der Zeichnung näher erläutert. Es zeigen:

Fig. 1 in schematischer, teilweise geschnittener Darstellung ein erstes Ausführungsbeispiel der Transportvorrichtung zur Durchführung des erfindungsgemässen Verfahrens,

Fig. 2 eine Detailvariante ausschnittsweise und

Fig. 3 den Greiferkopf eines zweiten Ausführungsbeispiels zur Durchführung des erfindungsgemässen Verfahrens.

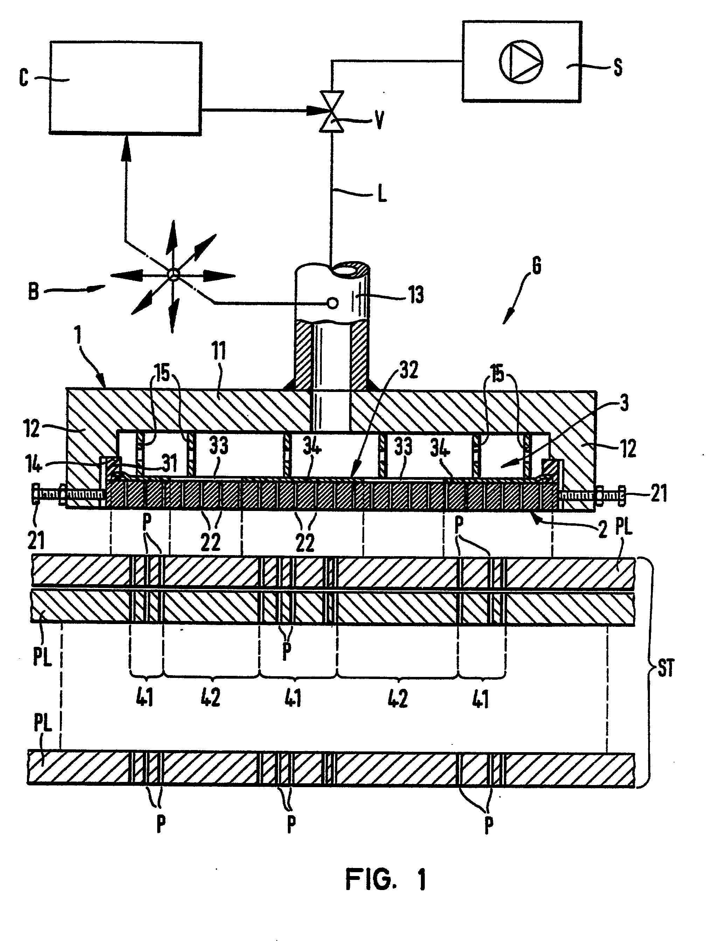

Gemäss Fig. 1 umfasst die Transportvorrichtung zur Durchführung des erfindungsgemässen Verfahrens einen als Ganzes mit G bezeichneten Greiferkopf, eine Saugvorrichtung S, an die der Greiferkopf G über eine ein Ventil V enthaltende flexible Leitung L angeschlossen ist, eine hier nur durch Pfeile B symbolisch angedeutete Bewegungseinrichtung für den Greiferkopf und eine Steueranordnung C zur Steuerung der Bewegungseinrichtung B und des Absperrventils V. Insofern entspricht die Transportvorrichtung bekannten Vorrichtungen dieser Art. Die Unterschiede gegenüber dem Stand der Technik liegen in der Ausbildung des Greiferkopfs G, und die folgende Beschreibung beschränkt sich daher im wesentlichen auf diesen.

Der Greiferkopf G besitzt ein im wesentlichen becherförmiges Gehäuse 1 von z.B. quadratischem Querschnitt mit einem Boden 11 und Seitenwänden 12. Der Gehäuseboden ist mit einem Anschlussnippel 13 für die Verbindungsleitung L zur Saugvorrichtung S ausgestattet. In die offene Unterseite des Gehäuses 1 ist eine ebene Saugplatte 2 eingesetzt, welche von Schrauben 21 gehalten wird und das Gehäuse bündig abschliesst. Die Saugplatte 2 weist über ihre gesamte Fläche gleichmässig verteilte Perforationen 22 auf und ist somit über die gesamte Fläche luftdurchlässig.

Auf der Innenseite der Saugplatte 2 ist eine Abdeckmaske 3 angeordnet, welche aus einer in einen Rahmen 31 eingespannten Folie 32 besteht. Die Folie 32 weist luftdurchlässige Fenster (Öffnungen, Durchbrüche) 33 auf, in den dazwischen liegenden Bereichen 34 ist sie jedoch luftundurchlässig. Der Rahmen 31 der Abdeckmaske 3 ist nur zwischen einer Schulter 14 in den Greiferkopfseitenwänden 12 und der Saugplatte 2 eingespannt, so dass die Abdeckmaske damit leicht auswechselbar ist. Rippen 15 drücken die Folie 32 gegen die Saugplatte 2 und verhindern dadurch ein Hochwölben im Betrieb.

Die Zeichnung zeigt einen Stapel ST von elektrischen Leiterplatten PL, welche jeweils in Bereichen 41 zahlreiche Perforationen (Bohrungen) P aufweisen. In den dazwischen liegenden Bereichen 42 sind keine (oder nur verhältnismässig wenige) Perforationen vorhanden. Die Anordnung der perforierten und nicht perforierten Bereiche ist durch das jeweilige Leiterbahnen-Lay Out bestimmt.

Zum Abnehmen einer Leiterplatte PL vom Stapel ST wird der Greiferkopf G auf die oberste Leiterplatte PL aufgesetzt und die Saugvorrichtung S aktiviert bzw. das Absperrventil V geöffnet. Durch den dadurch im Greiferkopfgehäuse 1 entstehenden Unterdruck saugt sich der Greiferkopf an der Leiterplatte fest und hält diese somit. Ohne die Abdeckmaske 3 wäre die Saugwirkung gleichmässig über die gesamte Fläche der Saugplatte 3 vorhanden und würde sich durch die Perforation P der Leiterplatten hindurch auch auf die darunterliegenden Leiterplatten ausdehnen, wodurch oft mehrere Platten zugleich vom Stapel abgehoben würden. Eine Einstellung der Saugleistung so, dass aufgrund des Gewichts jeweils nur die oberste Platte allein abgehoben würde, ist sehr kritisch und aufwendig und müsste bei einer Änderung der Leiterplattenart wieder von neuem gemacht werden.

Diese Schwierigkeiten werden nun erfindungsgemäss durch die Verwendung der Abdeckmaske 3 behoben. Bei dieser sind die luftdurchlässigen Fenster 33 so angeordnet, dass sie mit den keine oder nur relativ wenige Perforationen aufweisenden Bereichen 42 zusammenfallen. Die perforierten Bereiche 41 sind also durch die luftundurchlässigen Bereiche 32 der Abdeckmaske 3 abgedeckt. Auf diese Weise kann sich die Saugwirkung nicht durch die Perforationen hindurch auf die unteren Leiterplatten ausdehnen, und es ist einwandfrei gewährleistet, dass immer nur die oberste Leiterplatte PL allein vom Stapel ST abgehoben wird. Die Abdeckmaske 3 muss natürlich auf die Gestalt der jeweils zu transportierenden Leiterplatten abgestimmt sein, was jedoch bei der gewählten Konstruktion und der leichten Auswechselbarkeit keine Schwierigkeiten oder Umstände macht.

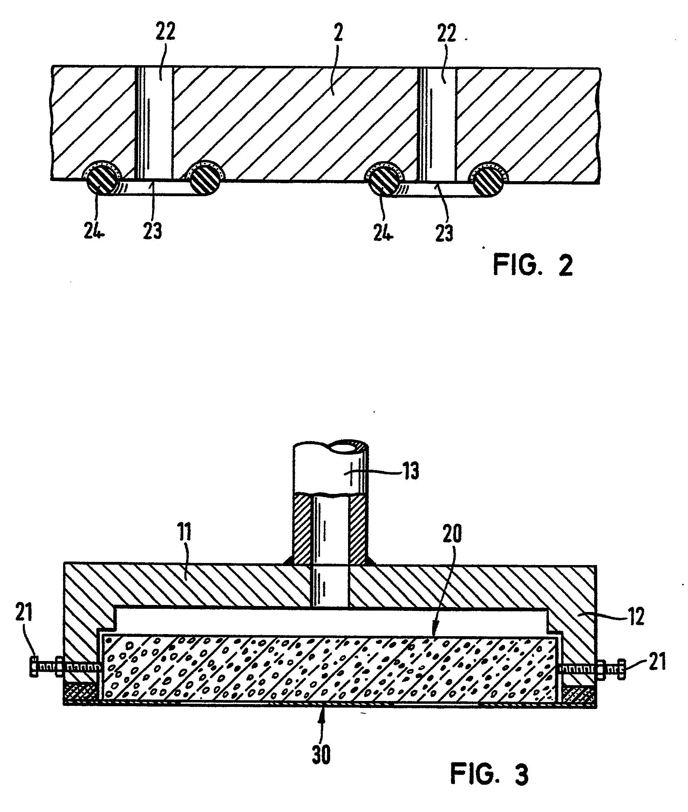

In Fig. 1 ist die dem zu tragenden Objekt zugewandte Unterseite der Saugplatte 2 eben ausgebildet. Zur Erhöhung der Haftung kann diese jedoch vorzugsweise gemäss Fig. 2 ausgestaltet sein, d.h. die einzelnen Perforationen 22 der Saugplatte 2 sind im Mündungsbereich 23 von einem elastischen Dichtungselement in Form eines o-Rings 24 oder eines (nicht dargestellten) Mikrosaugnapfs umschlossen. o-Ringe sind besonders vorteilhaft, weil sie dem Greiferkopf-Leiterplatten-Verbund eine relativ hohe Stabilität verleihen.

Gemäss Fig. 3 kann die Abdeckmaske 30 natürlich auch an der Aussenseite der Saugplatte 20 angeordnet sein. Die Saugplatte 20 selbst kann ferner auch, wie dargestellt, aus porösem, luftdurchlässigem Glas bestehen.

Die Fixierung der Abdeckmaske im Greiferkopf kann beliebig sein. Wesentlich ist, dass die Abdeckmaske leicht auswechselbar ist, so dass sie ohne grosse Umstände an die jeweiligen Leiterplatten angepasst werden kann.

Vorstehend wurde die Erfindung lediglich im Zusammenhang mit elektrischen Leiterplatten beschrieben. Selbstverständlich ist das erfindungsgemässe Transportverfahren auch für andere Objekte geeignet.

**Patentansprüche**

1. Verfahren zum einzelnen Abnehmen von mit einer Vielzahl von Perforationen versehenen plattenförmigen Objekten, im Speziellen von perforierten Leiterplatten, von einem Stapel solcher Objekte, mit einem an eine Saugvorrichtung (S) anschliessbaren Greiferkopf (G) zum Festhalten eines Objekts (PL) und einer Anordnung (C, B) zur Steuerung des Greiferkopfs, dadurch gekennzeichnet, dass der Greiferkopf G ein durch eine luftdurchlässige Saugplatte (2) abgeschlossenes Gehäuse (1) aufweist und mit einer Abdeckmaske (3) versehen wird, welche diejenigen Bereiche der Saugplatte (2) dichtend abdeckt, die mit den perforierten Bereichen der Objekte (PL) übereinstimmen, und damit saugaktive Bereiche der Saugplatte (2) festlegt.

2. Verfahren nach Anspruch 1, dadurch gekennzeichnet, dass die Abdeckmaske (3) auswechselbar im Greiferkopf (G) befestigt wird.

3. Verfahren nach Anspruch 1 oder 2, dadurch gekennzeichnet, dass als Abdeckmaske (3) eine an den gewünschten Stellen durchbrochene steife Folie (32) verwendet wird.

4. Verfahren nach Anspruch 3, dadurch gekennzeichnet, dass die Folie (32) in einen Rahmen (31) eingespannt ist.

5. Verfahren nach einem der Ansprüche 1–4, dadurch gekennzeichnet, dass die Abdeckmaske (3) an der Innenseite der Saugplatte (2) angeordnet wird.

6. Verfahren nach einem der Ansprüche 1–5, dadurch gekennzeichnet, dass als Saugplatte (20) eine Platte aus porösem Glas verwendet wird.

7. Verfahren nach einem der Ansprüche 1–5, dadurch gekennzeichnet, dass als Saugplatte (2) eine perforierte Metall- oder Kunststoffplatte verwendet wird, wobei die Perforationen (22) auf der Plattenaussenseite von elastischen Dichtelementen (24) umschlossen werden.

8. Verfahren nach Anspruch 7, dadurch gekennzeichnet, dass die Dichtelemente je durch einen teilweise in der Plattenoberfläche versenkt befestigten, die Mündung (23) der Perforationen (22) umschliessenden o-Ring (24) gebildet werden.

9. Anwendung des Verfahrens nach einem der vorangehenden Ansprüche zum Abnehmen von perforierten elektrischen Leiterplatten von einem Stapel gleichartiger Platten.

**Claims**

1. Method for the individual removal of plate-shaped objects provided with a plurality of perforations, in particular of perforated circuit boards, from a stack of such objects, with a gripper head (G) which can be connected to a suction device (S) for holding an object (PL) and a device (C, B) for controlling the gripper head, characterised in that the gripper head (G) has a housing (1) which is closed by an air-permeable suction plate (2) and is provided with a cover mask (3) which sealingly masks those areas of the suction plate (2) which correspond to the perforated areas of the objects (PL), and thus establishes suctionally active areas of the suction plate (2).

2. Method according to Claim 1, characterised in that the cover mask (3) is replaceably mounted in the gripper head (G).

3. Method according to Claim 1 or 2, characterised in that a rigid film (32) which is perforated at the desired points is used as the cover mask (3).

4. Method according to Claim 3, characterised in that the film (32) is clamped in a frame (31).

5. Method according to one of Claims 1–4, characterised in that the cover mask (3) is mounted on the inside of the suction plate (2).

6. Method according to one of Claims 1–5, characterised in that a plate of porous glass is used as the suction plate (20).

7. Method according to one of Claims 1–5, characterised in that a perforated metal or plastic plate is used as the suction plate (2), the perforations (22) being surrounded by elastic sealing elements (24) on the outside of the plate.

8. Method according to Claim 7, characterised in that the sealing elements are each formed by an o-ring (24) which is mounted partially sunk into the plate surface and surrounding the opening (23) of the perforations (22).

9. Use of the method according to one of the preceding Claims for the removal of perforated electric circuit boards from a stack of similar boards.

**Revendications**

1. Procédé destiné au prélèvement individuel d'objets en forme de plaques, munis d'un grand nombre de perforations, en particulier de plaques conductrices perforées, à partir d'une pile de tels objets, à l'aide d'une tête (G) de saisie susceptible d'être raccordée à un dispositif (S) d'aspiration, destiné à maintenir solidement un objet (PL), et d'un dispositif (C, B) destiné à commander la tête de saisie, procédé caractérisé en ce que la tête (G) de saisie présente un corps (1) fermé par une plaque (2) d'aspiration perméable à l'air et en ce qu'elle est munie d'un cache (3) de recouvrement, qui recouvre hermétiquement celles des zones de la plaque (2) d'aspiration qui correspondent aux zones perforées des objets (PL) et qui détermine ainsi les zones, susceptibles d'avoir une activité d'aspiration, de la plaque (2) d'aspiration.

2. Procédé selon la revendication 1, caractérisé en ce que le cache (3) de recouvrement est fixé dans la tête (G) de saisie de manière à pouvoir être changé.

3. Procédé selon la revendication 1 ou 2, caractérisé en ce que l'on utilise en tant que cache (3) de recouvrement, une feuille (32) rigide comportant des passages aux endroits souhaités.

4. Procédé selon la revendication 3, caractérisé en ce que la feuille (32) est enserrée dans un cadre (31).

5. Procédé selon l'une des revendications 1 à 4, caractérisé en ce que le cache (3) de recouvrement est disposé contre le côté intérieur de la plaque (2) d'aspiration.

6. Procédé selon l'une des revendications 1 à 5, caractérisé en ce que l'on utilise, en tant que plaque (20) d'aspiration, une plaque de verre poreux.

7. Procédé selon l'une des revendications 1 à 5, caractérisé en ce qu'on utilise, en tant que plaque (2) d'aspiration, une plaque de métal ou de matière plastique perforée, les perforations (22) étant entourées sur le côté extérieur de la plaque par des éléments élastiques (24) d'étanchéité.

8. Procédé selon la revendication 7, caractérisé en ce que les éléments d'étanchéité sont formés chacun par un joint torique (24) fixé en étant enfoncé partiellement dans la surface de la plaque et entourant le débouché (23) des perforations (22).

9. Application du procédé selon l'une des revendications précédentes au prélèvement de plaques conductrices de l'électricité, ces plaques étant perforées et à prélever sur une pile de plaques du même genre.

FIG. 1

FIG. 2

FIG. 3